# EUROPEAN PATENT APPLICATION

(11) **EP 0 845 770 A1**
(43) Date of publication of application: **03.06.1998**
(21) Application number: 97120761.8
(22) Date of filing: 26.11.1997
(51) Int. Cl.: G09G 3/32

(54) **Organic electroluminescence display apparatus**

(30) Priority: 29.11.1996 JP 319307/96
(71) Applicant: TDK Corporation, Chuo-ku, Tokyo (JP)
(72) Inventor: Arai, Michio, Koganei-shi, Tokyo (JP)
(74) Representative: Grünecker, Kinkeldey, Stockmair & Schwanhäusser Anwaltssozietät

(57) **Abstract**

An organic EL display apparatus comprising, for each pixel, an organic EL element having a light emitting layer including an organic composition between an anode and a cathode, a non-linear element made by an N-type FET for controlling light emission of said organic EL element, a drain of said N-type FET being connected to a cathode electrode of said organic EL element, a capacitor connected to a gate electrode of the non-linear element for holding a signal, and a non-linear element for writing data into the capacitor. Further, a color filter formed on a transparent substrate is arranged opposite to said organic EL element.

## Description

### BACKGROUND OF THE INVENTION

The present invention relates to an active matrix organic EL (Electro Luminescence) display apparatus, and more particularly to an organic EL display apparatus which is small in size and highly integrated.

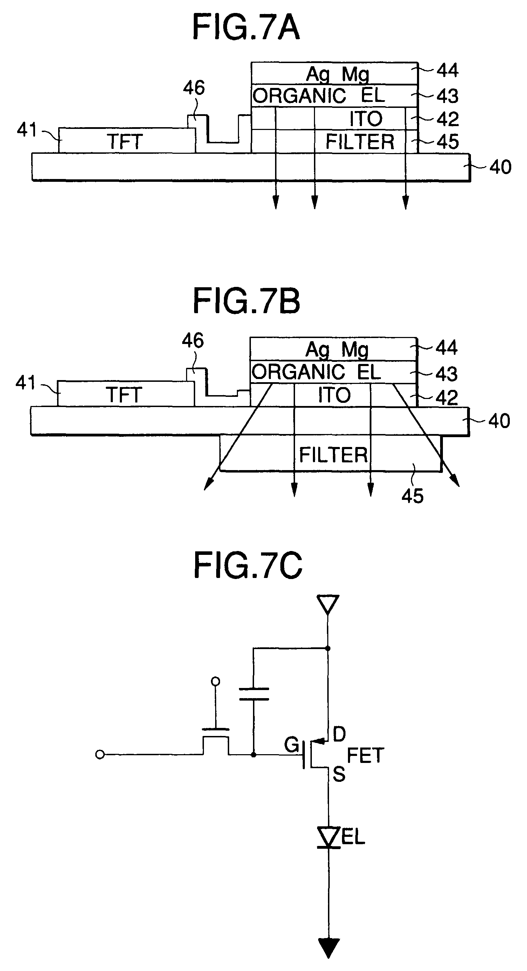

A color organic EL display apparatus, as illustrated in Fig. 7A, has a thin film transistor (hereinafter referred to as "TFT") 41 formed on a quartz or glass substrate 40 as well as a filter 45, a transparent electrode 42 made of a material such as ITO (Indium Tin Oxide), an organic EL layer 43 composed of a hole transport layer, a light emitting layer, an electron transport layer and so on, and a cathode 44 made of a material such as Ag-Mg formed on the same substrate 40.

Within the layers mentioned above, the transparent electrode 42, the organic EL layer 43, and the cathode 44 constitute an organic EL element. Light emitted from the organic EL layer 43 is outputted through the filter 45. Fig. 7A is a schematic diagram illustrating one unit of R, G, B pixels constituting one pixel of a color organic EL display apparatus.

When the color organic EL display apparatus is configured as illustrated in Fig. 7A, a large step-like difference is formed in a wire 46 which connects the TFT 41 to the transparent electrode 42 of the organic EL element. When the filter 45 is positioned on the rear surface of the substrate 40 opposite to the surface on which the organic EL element is formed, as illustrated in Fig. 7B, for purposes of eliminating the drawback mentioned above, the thickness of the substrate 40 causes emitted light to spread, so that the size of one pixel is larger and the resolution is degraded.

Also, as illustrated in Figs. 7A and 7B, the TFT 41 is connected to the transparent electrode 42, which serves as an anode of the organic EL element, and the TFT 41 is formed of a P-type FET since the transparent electrode 42 performing a hole injecting function through the boundary with the organic EL layer.

In an active matrix EL image display apparatus comprising pixels each of which is formed of a thin film EL element, a non-linear element such as the above-mentioned TFT for controlling light emission for an EL element, a capacitor connected to a gate electrode of the non-linear element for holding a signal, and a non-linear element for writing data into the capacitor, the intensity of light emitted from the organic EL is determined by a current, which flows into the non-linear element for controlling the light emission, where the current is controlled by a voltage accumulated in the capacitor for holding a signal (see A6x6-in 20-Ipi Electroluminescent Display Panel: T. P. BRODY, FANG CHEN LUO, ZOLTAN P. SZEPESI, DAVID H. DAVIES, IEEE Transactions on Electron Devices, Vol. ED-22, No. 9, September 1975, pp 739-749).

An organic EL element has a structure, for example, composed of a substrate, an anode / a hole injection layer / a light emitting layer / an electron transport layer / a cathode, wherein an organic composition is used at least in the light emitting layer. While the hole injection layer and the electron transport layer are not necessarily provided, they are desirable for improving the light emitting performance.

When an image display apparatus is constructed using the organic EL element as mentioned above, the element is separated by performing fine machining on the anode, while one terminal of the non-linear element for controlling the light emission such as TFT is connected to the anode by performing element separation (see USP No. 5,550,066).

When an N-type FET is used for the non-linear element connected to the anode, a source electrode of the FET is connected to the anode of the organic EL element due to the nature of the N-type FET. As illustrated in Fig. 7C, this connection forms a source follower circuit of the N-type FET including the organic EL element as a load.

In this configuration, since the organic EL element has a non-linear load characteristic, an image display apparatus employing this circuit requires a correcting means in a peripheral circuit for inputting a non-linearly corrected image signal, or the like in order to realize a good gradation representation. The addition of such a correcting means results in an increase in cost of the entire image display apparatus.

On the other hand, when a P-type FET is used for the non-linear element connected to the anode, the anode of the organic EL element is connected to a drain electrode of the FET due to the nature of the P-type FET. These elements form a source-grounded circuit of the P-type FET including the organic EL element as a load.

For realizing a good gradation representation in an image display apparatus employing the circuit mentioned above, an image signal may only be linearly amplified to a value appropriate to the circuit and then inputted thereto. It should be noted however that since the P-type FET is inferior in mobility to the N-type FET, the size of the P-type FET must be larger for providing good characteristics. In addition, the P-type FET is not appropriate to a high resolution image display apparatus.

Further, the high-temperature resistance of the organic EL material is approximately 100°C. However, when color resists are applied on a substrate for forming color filters, they must be baked at temperatures ranging from 120 to 150°C. Thus, a problem arises in that the baking adversely affects the organic EL element.

### SUMMARY OF THE INVENTION

It is therefore an object of the present invention to provide an active matrix organic EL image display apparatus which eliminates the problems mentioned above and employs an N-type FET to realize a reduced cost and a high resolution.

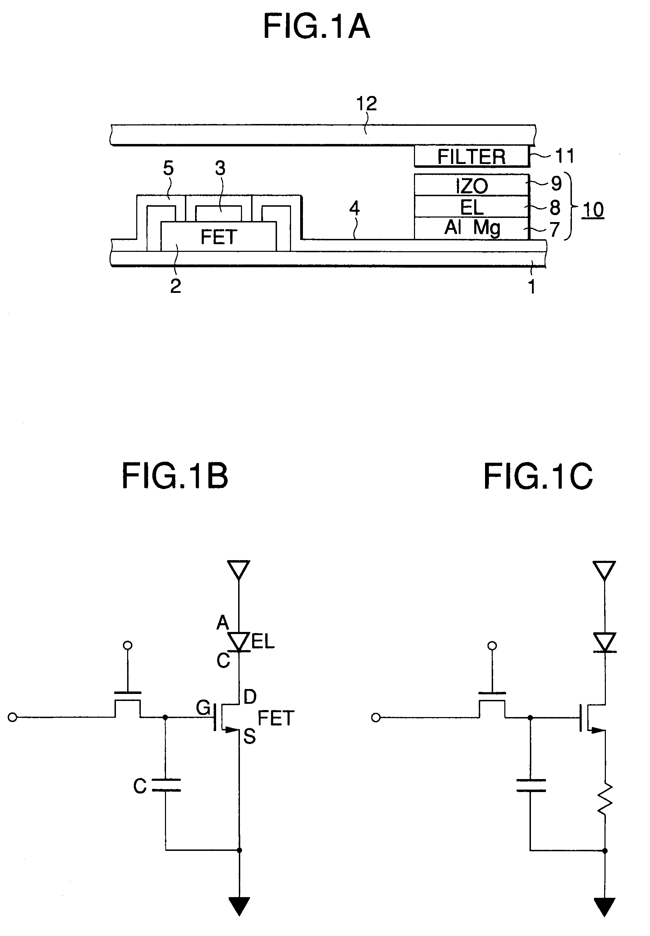

To achieve the above object, in the present invention, an N-type FET 2 is formed on a substrate 1 made of quartz, glass, ceramic, alumina, or the like, as illustrated in Fig. 1A. The N-type FET 2 is provided with a gate electrode 3 and wires 4, 5. An organic EL element 10 comprising a cathode 7, an organic EL layer 8, and a transparent electrode 9 is arranged on the wire 4 on the drain side. Also arranged is a transparent plate 12 such as a glass plate, on which a color filter 11 is formed opposite to the transparent electrode 9 which functions as an anode of the organic EL element.

The cathode 7 is formed, for example, of an AgMg electrode, the organic EL layer is composed of an electron transport layer, a light emitting layer, a hole injection layer and so on, and the transparent electrode 9, i.e., the anode, is made, for example, of IZO (indium zinc oxide). The organic El element is separated by the cathode 7.

In this structure, the N-type FET has its drain electrode connected to the cathode 7 of the organic EL element 10 due to the nature of the N-type FET. In this way, a source grounded circuit of the N-type FET is configured with the organic EL element 10 included as a load element, as illustrated in Fig. 1B.

Thus, for providing a good gradation representation on this image display apparatus employing the circuit mentioned above, an image signal may be linearly amplified to a value appropriate to the circuit and then inputted thereto.

For displaying a signal in accordance with the NTSC standard, an image signal has been applied with γ correction with a supposed γ value being 2.2 or less when it is outputted from an image device. When such a luminance correction is performed, the γ characteristic of the luminance for an input signal voltage of an image display apparatus using a source grounded circuit of an N-type FET, including the organic EL element as a load, is approximately two which is close to the supposed γ value, so that favorable gradation can be provided only by linearly amplifying the image signal to a value appropriate to this circuit.

In a conventional source follower circuit including the organic EL element as a load, since it is difficult to approach a maximum gradient of a load curve of the organic EL element represented in a bi-logarithmic scale to 2.2, a means is required for supplying this circuit with an image signal after it has been applied with non-linear correction processing in a peripheral circuit.

Conversely, in an image signal system other than the NTSC standard, for which the gamma correction is not performed, i.e., for which the gamma correction is not performed on a luminance-versus-output curve, i.e., which exhibits the gamma characteristics approximately one for the luminance-versus-output curve, a drain electrode of an N-type FET is connected to a cathode of an organic EL element, and a load having a good linear load characteristic is arranged at a source electrode of the N-type FET. In this way, a source grounded circuit of the N-type FET including a load element having good linearity is configured as illustrated in Fig. 1C.

For this load, polysilicon or a source resistor of the FET may be utilized. The γ characteristic of the luminance to an input signal voltage to an image display apparatus using this circuit is one and coincident with the γ value of an image system, so that good gradation can be realized only by linearly amplifying an image signal to a value appropriate to the circuit.

In a conventional source follower circuit including the organic EL element as a load, since it is difficult to approach a maximum gradient of a load curve represented in a bi-logarithmic scale to 1, a means is required for supplying this circuit with an image signal after it has been applied with non-linear correction processing in a peripheral circuit.

### BRIEF DESCRIPTION OF THE DRAWINGS

Fig. 1A is a cross-section diagram of an organic EL display apparatus according to the present invention;
Figs. 1B and 1C are equivalent circuit diagram of a driving circuit of the organic EL display apparatus as shown in Fig. 1A
Figs. 2A to 2G are explanatory diagrams illustrating manufacturing steps of an N-type FET used in the present invention;
Figs. 3A to 3D are explanatory diagrams showing how an organic EL element is formed in the present invention;
Fig. 4 is a graph illustrating the light emission characteristics of the organic EL element;
Fig. 5 is an explanatory diagram illustrating a color filter;
Fig. 6 is an explanatory diagram showing how an organic EL element is combined with a color filter;
Figs. 7A and 7B are explanatory diagrams showing the conventional organic EL display apparatus; and
Fig. 7C is a equivalent circuit diagram of a driving circuit of the conventional organic EL display apparatus.

### DETAILED DESCRIPTION OF THE PREFERRED EMBODIMENTS

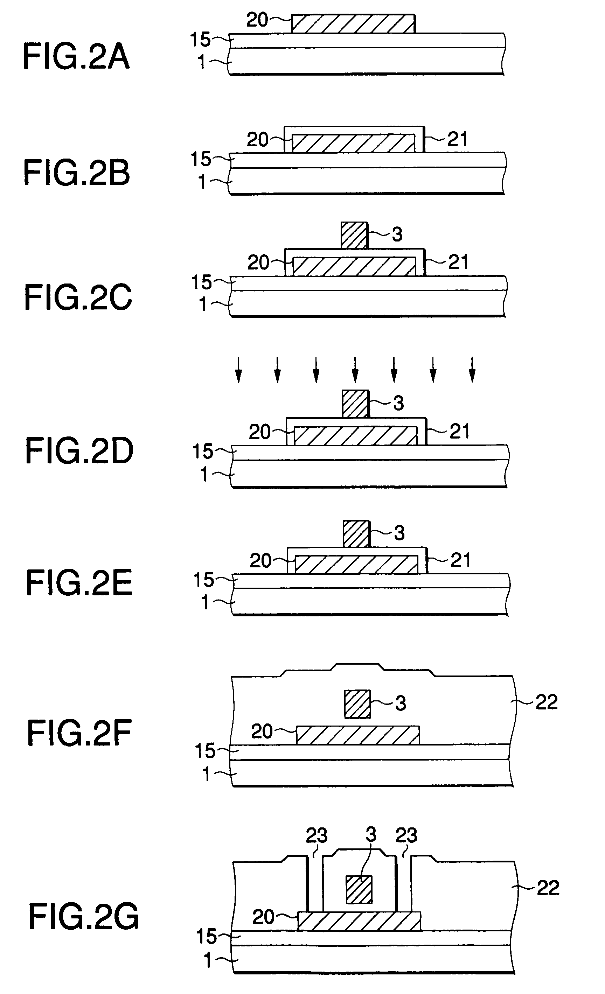

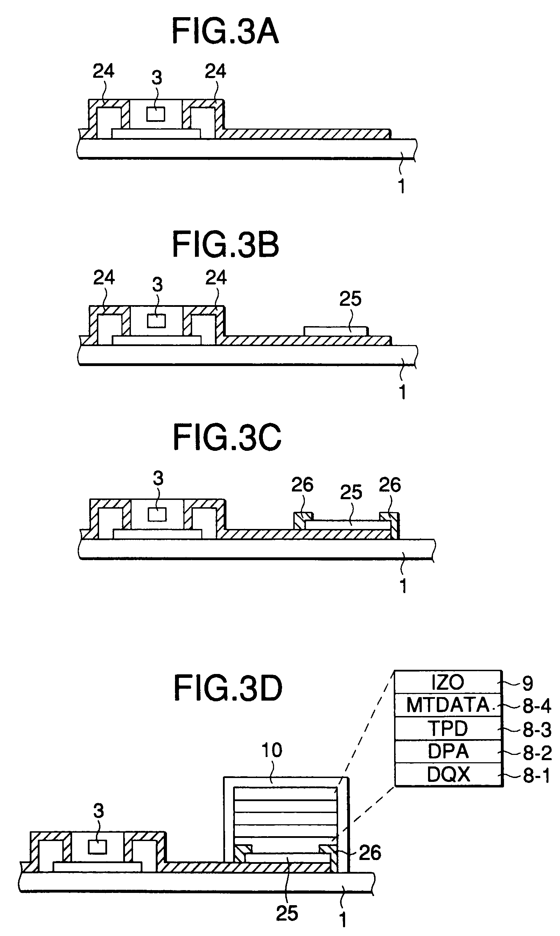

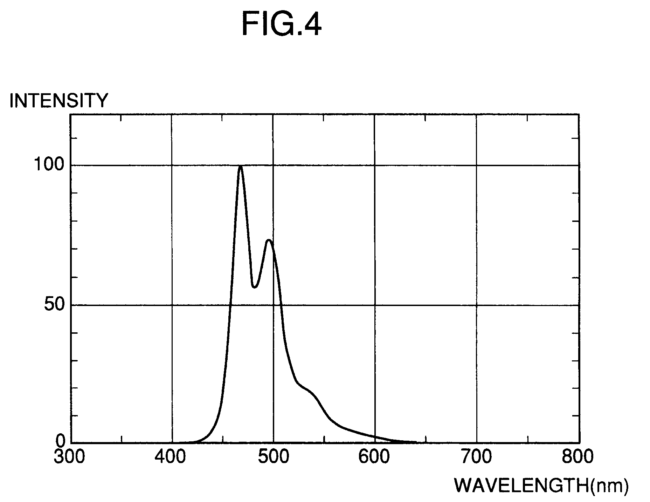

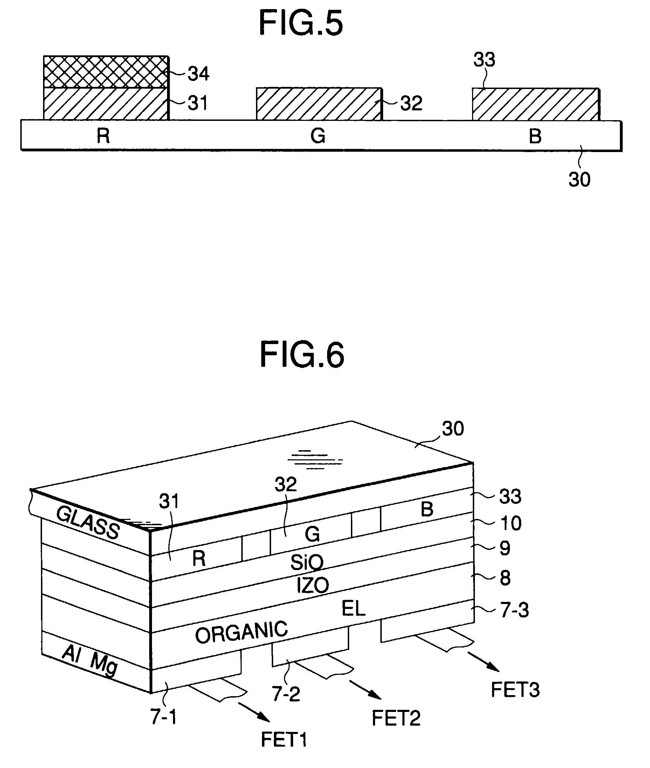

One embodiment of the present invention will be described with reference to Figs. 2 - 6. Figs. 2A - 2G are explanatory diagrams for illustrating various steps of manufacturing an N-type FET used in the present invention; Figs. 3A - 3D are explanatory diagrams for showing how an organic EL element is formed for the FET; Fig. 4 is a graph for explaining the light emitting characteristics of the organic EL element used in the present invention; Fig. 5 is a cross-sectional view illustrating color filters used in the present invention; and Fig. 6 is a perspective view showing how the organic EL element and the color filters are combined in the present invention.

The steps of manufacturing the thin-film N-type FET transistor used in the present invention will be explained with reference to Figs. 2A to 2G and 3A to 3D.

First, as shown in Fig. 2A, a SiO₂ layer 15 is formed on a quartz or glass substrate 1, for example, by a sputtering method in a thickness of approximately 1000 Å. Then, an amorphous silicon layer is formed on the SiO₂ layer, for example, by a CVD method in a thickness of approximately 1000 Å. These layers are formed under conditions, for example, as follows:
- Si₂H₆ Gas:: 100 SCCM (Standard Cubic Cm per Minute)
- Pressure:: 0.3 Torr
- Temperature:: 480 °C

Subsequently, the amorphous silicon layer is grown in a solid phase to be transformed into a polysilicon layer. The solid phase growth is performed under conditions, for example, as follows:
- N₂ :: 1 SLM (Standard Liter per Minute)
- Temperature:: 600 °C
- Processing Time:: 5 hr - 20 hr

Subsequently, the polysilicon layer is patterned to form an active silicon layer 20 (Fig. 2A).

Next, as shown in Fig. 1B, a Si0₂ layer, eventually serving as a gate oxide film 21, is formed on the active silicon layer 20, for example, by a plasma CVD method in a thickness of approximately 1000 Å. The Si0₂ layer is formed under conditions, for example, as follows:
- Power:: 50 W
- TEOS (Tetraethoxysilan) Gas:: 50 SCCM
- O₂:: 500 SCCM
- Pressure:: 0.1 - 0.5 Torr
- Temperature:: 350 °C

Ten, as shown in Fig. 2C, an amorphous silicon layer, eventually serving as a gate electrode 3, is formed on the SiO₂ layer 21 by a CVD method in a thickness of approximately 4000 Å, for example, under the same conditions as the aforementioned step of Fig. 2A. Then, the amorphous silicon layer is annealed, for example, under the same conditions as the aforementioned step of Fig. 2A to form a polysilicon layer which eventually serves as the gate electrode 3. Subsequently, the polysilicon layer and the SiO₂ layer formed in the above step of Fig. 2B are patterned together, for example, by dry etching to form the gate electrode 3 and the gate oxide film 21.

Subsequently, as shown in Fig. 2D, the gate electrode 3 is used as a mask to dope an N-type impurity, for example, phosphorus (P) into regions within the silicon active layer 20, which are to function as a source region and a drain region, by an ion doping method.

Next, as shown in Fig. 2E, the structure is annealed in a nitrogen atmosphere at approximately 550°C for five hours to activate the dopants. The structure is further annealed in a hydrogen atmosphere at approximately 400°C for 30 minutes for hydrogenation to reduce a defect level density of the semiconductor.

Then, as shown in Fig. 2F, a SiO₂ layer, eventually serving as an inter-layer insulating layer 22, is formed over the entire substrate in a thickness of approximately 4000 Å, with TEOS used as a starting material. The SiO₂ layer serving as the inter-layer insulating layer 22 is formed under conditions, for example, as follows:
- Power:: 50 - 300 W
- TEOS Gas:: 10 - 50 SCCM
- O₂:: 500 SCCM
- Pressure:: 0.1 - 0.5 Torr
- Temperature:: 350 °C

As shown in Fig. 2G, the SiO₂ layer eventually serving as the inter-layer insulating layer 22 is formed with a hole 23 for etching contact.

Subsequently, an Al wire 24 is vapor deposited as illustrated in Fig. 3A.

Next, as illustrated in Fig. 3B, Al·Mg metal (Mg: 90 mole percent) 25, eventually serving as a cathode, is vapor deposited in a region in which the organic EL element is positioned. Alternatively, any material having a work function equal to or lower than approximately 4 eV may be used instead of the Al·Mg metal. Then, wire portions are patterned.

Polyimide 26 is covered over the region in which the organic EL element is positioned, while the Al·Mg metal is exposed only for a light emitting portion (see Fig. 3C).

Then, as shown in Fig. 3D, the Al·Mg metal 25 in the light emitting portion is sputter etched in a multi-chamber to etch an oxide film on the surface thereof. Subsequently, DQX as represented by Chemical Formula 1 for constituting an electron transport layer 8-1, DPA as represented by Chemical Formula 2 for constituting a light emitting layer 8-2, TPD as represented by Chemical Formula 3 for constituting a hole transport layer 8-3, and MTDATA as represented by Chemical Formula 4 for constituting a hole injection layer 8-4 are formed in this order, for example, by vapor deposition to form the organic EL layers. In Chemical Formula 2, Rn represents a methyl group or an ethyl group.

Subsequently, a transparent conductive film, IZO 9 (In₂O₃·ZnO (5 mol%) is formed as an anode on the organic EL layers, and a SiO₂ film 10 is formed on the IZO 9 for SiO₂ encapsulation to connect the organic EL element to a drain side of the N-type FET, as illustrated in Fig. 3D. In this event, a load resistor exhibiting a linear characteristic is implemented by using the gate polysilicon or the active silicon of the N-type FET. Alternatively, ITO (In₂O₃, SnO₂ (10 mol%)) or the like may be employed as the transparent conductive film instead of IZO.

The organic EL element exhibits waveform versus output intensity characteristics (relative value) as illustrated in Fig. 4 and emits blue green light.

A color filter for use in this organic EL element is such one as illustrated in Fig. 5 which has a read filter 31, a green filter 32, and a blue filter 33 arranged on a glass plate 30. For enhancing the intensity of light emitted through the red filter 31, an fluorescent filter 34 is stacked only on the red filter 31. Then, the color filter as illustrated in Fig. 5 is aligned to the substrate 1 on which the N-type FET and the organic EL element have been formed as illustrated in Fig. 3H, and both are bonded. For simplifying the explanation, the substrate 1, FET, fluorescent filter 34, and so on are omitted from Fig. 6.

As is apparent from Fig. 6, the AlMg cathode is separated into regions 7-1, 7-2, 7-3 corresponding to N-type FETs for controlling R, G, B. Therefore, this organic EL element has a separate cathode configuration.

While the foregoing embodiment has been described in connection with an example in which an N-type FET is formed of polysilicon as a thin film, the present invention is not limited to this particular material. Alternatively, the TFT may be formed of crystal silicon or amorphous silicon. When crystal silicon is used, a high mobility N-type FET can be provided, so that the size of the N-type FET can be reduced. When using amorphous silicon, the N-type FET can be formed at a lower cost.

Also, while the foregoing embodiment has employed a quartz or glass substrate for the substrate 1, the present invention is not limited to this particular substrate. In the conventional organic EL display apparatus, light is emitted through a transparent substrate, whereas in the structure of the present invention, the light emitting surface is positioned on the opposite surface, so that the substrate need not be transparent. It is therefore possible to use a ceramic substrate, an alumina substrate, or the like as long as it has required mechanical strength, flatness, and high-temperature resistance.

Further, while the foregoing explanation has been made in connection with an example in which a source resistor is used as a linear load connected to a source electrode, the present invention is not limited to this load. Alternatively, a load having linear characteristics may be connected to the source electrode using an N-type polysilicon for the lead wire. Further alternatively, a load resistor may be formed of gate polysilicon. When a source resistor is used, a desired resistance value can be provided by slightly extending a doped active layer on the source side.

The aforementioned polyimide resin (polyimide 26 shown in Fig. 3C) is provided for separating a light emitting element, and may be formed using SiO₂, silicon nitride, or the like.

While the organic EL element has been described as having an anode - a hole injection layer - a hole transport layer - a light emitting layer - an electron transport layer - a cathode, the present invention is not of course limited to this particular structure of organic EL element. Alternatively, the organic EL element may be formed of an anode - a hole transport layer - a light emitting layer - an electron transport layer - a cathode, an anode - a light emitting layer - an electron injection layer - a cathode, or any other appropriate structure.

According to the present invention, since a portion for controlling the organic EL element can be entirely formed of high mobility N-type FETs, it is possible to provide a reduced size, a higher integration degree, and an improved resolution at a lower manufacturing cost.

While the foregoing explanation has been made in connection with an example which employs an organic EL element for emitting blue green light that exhibits the characteristics as illustrated in Fig. 4, the present invention is not of course limited to this particular type of organic EL element. Alternatively, a variety of other organic EL elements may be used, for example, an organic EL element for emitting white light which is provided with a RGB color filter, an organic EL element for emitting blue light which is provided with G, R fluorescent filters and a RGB color filter overlying the fluorescent filters, and an organic EL element for emitting blue light and red light which is provided with a G fluorescent filter and a RGB color filter overlying the fluorescent filter.

When n-type amorphous SiC is used as an electron injection layer, p-type amorphous SiC is used as a hole transport layer, and tris(8-hydroxyquinoline) aluminium represented by the following Chemical Formula 5 is used as a light emitting layer, a mixture of n-type amorphous SiC and p-type amorphous SiC may be used as a light emitting layer.

Since a cathode of a non-linear element for controlling light emission of an organic EL element is connected to the drain side of an N-type FET, a light emission control circuit for the organic EL element can be formed of a high mobility N-type FET, thereby making it possible to provide an organic EL display apparatus having a higher integration degree, a smaller size, and an improved resolution.

Since the N-type FET is formed of single crystal silicon, the resulting light emission control circuit exhibits a particularly high mobility, thereby making it possible to provide a small and high resolution organic EL display apparatus with a much higher integration degree.

Since the N-type FET is formed of polysilicon, a high mobility light emission control circuit can be reduced in size. In addition, an arbitrary substrate may be used unlike the case where single crystal silicon is used, so that selection freedom can be increased for the substrate.

Since the N-type FET is formed of amorphous silicon, a high mobility light emission control circuit can be configured using an inexpensive substrate.

Since a load having a good linearity is arranged at the source electrode of the N-type FET, it is possible to provide a luminance control circuit having a good linearity without requiring a correcting circuit.

Since a color filter or a color filter and an fluorescent filter are arranged on a different substrate from that on which the organic EL element is formed, the organic EL element and the color filter can be formed on separate substrates. For this reason, the yield can be improved as compared with the formation of those components on the same substrate wherein an overall yield is calculated by accumulating yields at respective manufacturing processes. In another aspect, the high-temperature resistance of the current organic EL material is approximately 100°C. When color resists are applied for forming a color filter on the organic EL material, they must be baked at 120°C - 150°C. Thus, it has been quite difficult for the prior art to form the color filter without adversely affecting the organic EL material. On the other hand, since the present invention can manufacture these components separately, it is possible to provide a good organic EL display apparatus at a high yield because the organic EL element is not deteriorated by the baking of color resists.

By employing polysilicon for a fairly linear load, the load can be formed by ordinary silicon TFT manufacturing techniques without using special materials or manufacturing steps.

Since a source resistor of the N-type FET is used as a load having linearity, the circuit can be operated without additionally providing a special load in the circuit.

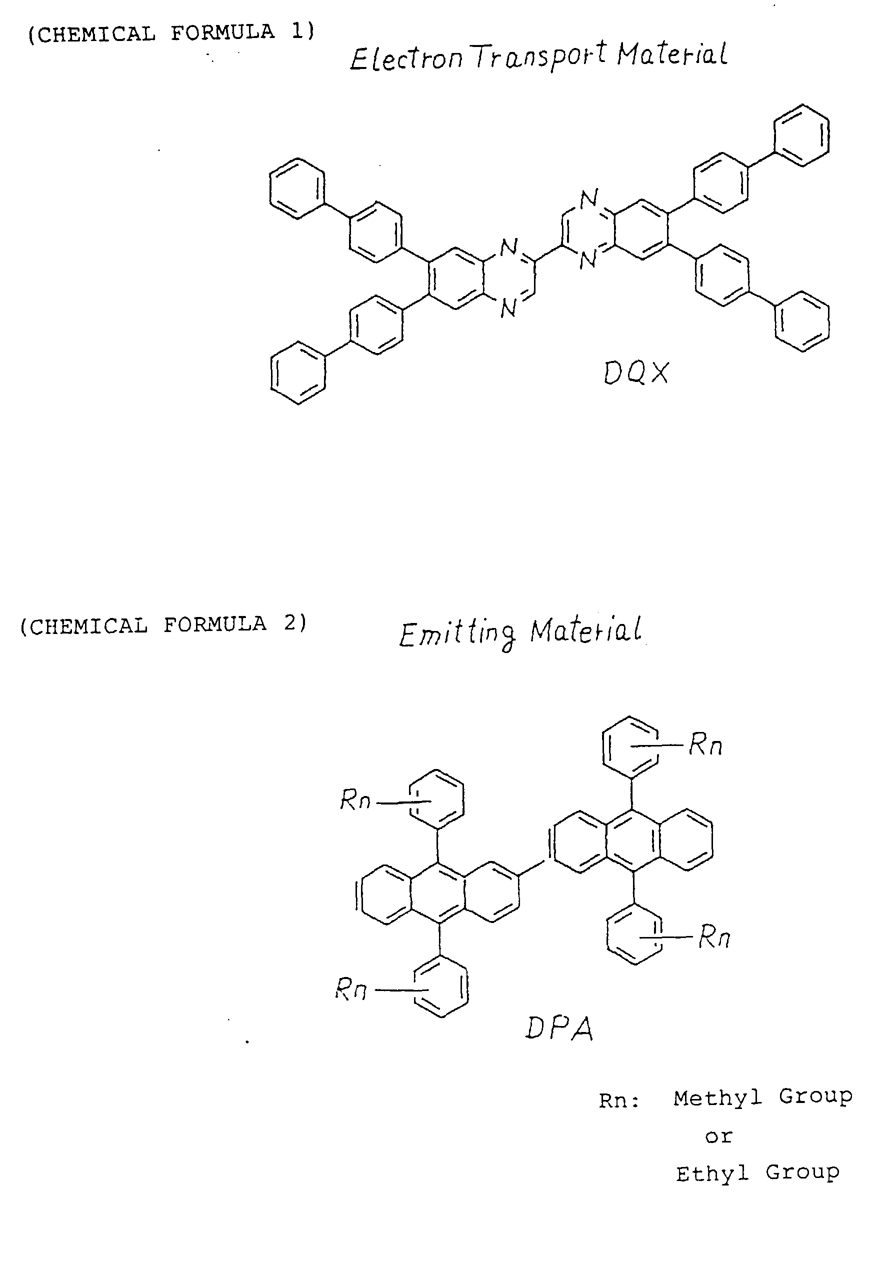

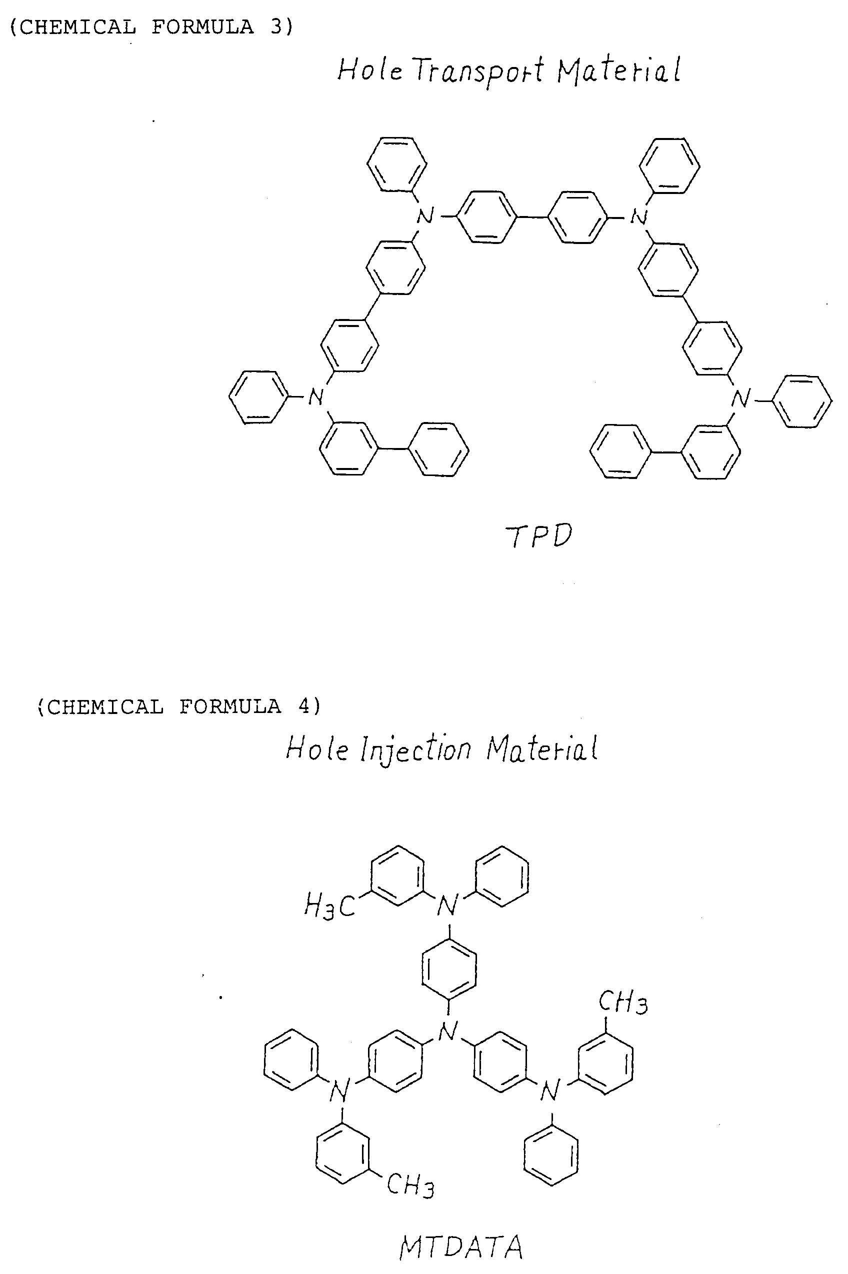

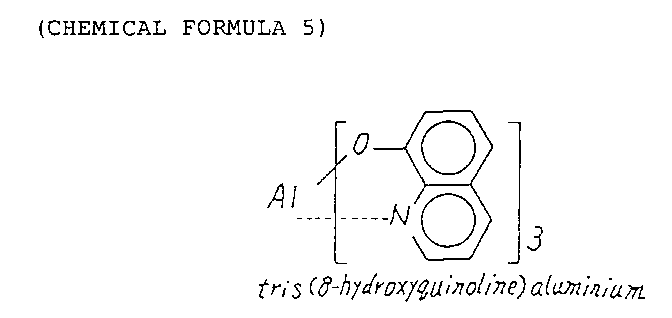

## Claims

1. An organic electroluminescence (EL) display apparatus, for each pixel, comprising:
an organic EL element having a light emitting layer including an organic composition between an anode and a cathode;
a non-linear element made by an N-type FET for controlling light emission of said organic EL element, a drain of said N-type FET being connected to a cathode electrode of said organic EL element;
a capacitor connected to a gate electrode of said non-linear element for holding a signal; and
a non-linear element for writing data into said capacitor.

2. An organic EL display apparatus further comprising a color filter on a transparent substrate arranged opposite to said organic EL element.

3. An organic EL display apparatus as claimed in claim 2, wherein said color filter includes a read filter, a green filter, and a blue filter.

4. An organic EL display apparatus as claimed in claim 3, further comprising an fluorescent filter on said read filter.

5. An organic EL display apparatus as claimed in claim 1, wherein said N-type FET for controlling light emission comprises a TFT of silicon formed on a substrate.

6. An organic EL display apparatus as claimed in claim 5, said substrate is made of quartz, glass, ceramic, or alumina.

7. An organic EL display apparatus as claimed in claim 5, wherein said TFT is of one of a single crystal silicone, popysilicon, or amorphous silicon.

8. An organic EL display apparatus as claimed in claim 1, wherein a load having linearity is arranged at a source electrode of said N-type FET for controlling light emission.

9. An organic EL display apparatus as claimed in claim 8, wherein said load having linearity is made of polysilicon.

10. An organic EL display apparatus as claimed in claim 8, wherein said load having linearity is implemented using a source resistor of the N-type FET.
